# EUROPEAN PATENT APPLICATION

(11) **EP 4 053 570 A1**
(43) Date of publication of application: **07.09.2022**
(21) Application number: 22154124.6
(22) Date of filing: 29.01.2022
(51) Int. Cl.: G01R 27/14, G01R 31/12, H01L 49/02, G01R 27/04

(54) **METHOD FOR TESTING IMPURITIES IN METAL LAYER OF RESISTOR**

(30) Priority: 04.03.2021 TW 110107723
(71) Applicant: Viking Tech Corporation, Hukou Township Hsin chu 303 (TW)
(72) Inventor: LU, CHI-YU, Hsinchu County (TW); KUO, MING-CHIEH, Hsinchu County (TW)
(74) Representative: Schwerbrock, Florian

(57) **Abstract**

A method to measure the impurity content in a metal layer of a resistor is proposed. A pulse voltage is applied on the metal layer and then a resonance wave is created. The resonance wave can be used to measure the impurity content by comparing the waveform with a standard waveform.

## Description

### BACKGROUND OF THE INVENTION

### 1. FIELD OF THE INVENTION

The present invention discloses a method for detecting impurities in the metal layer of a resistance element and especially by measuring variation of resonance wave.

### 2. DESCRIPTION OF THE PRIOR ART

Any chip resistor and columnar resistor etc., kind of passive component, comprise one or more metal layers. The organic or inorganic substance may be mix into the metal layer during the manufacturing process, and these impurities impact the resistance and lifetime of the resistance element.

The convention method detects the resistance of the metal layer of the resistor not the impurity. The metal layer has a standard resistance even it has impurities.

### SUMMARY OF THE INVENTION

A non-destructive, high-speed and low-energy pulse voltage is applied to a resistor, and then the metal layer of the resistor generates resonance wave. The abnormal decay or fluctuations of the resonance wave can be used to determine the impurity content.

A method of detecting impurity content in a metal layer of a resistor, comprising:
applying a pulse voltage to a non-impurity resistor to establish a standard resonance wave;
applying the pulse voltage to a test resistor to obtain a test resonance wave;
comparing the standard resonance wave with the test resonance wave to calculate a variation rate; and
determining the impurity content of the test resistor:
   the variation rate is over a threshold, the impurity content is too much; or
   the variation rate is not over a threshold, the impurity content is compliant.

A method of detecting impurity content in a metal layer of a resistor, comprising:
applying a pulse voltage to the resistor to obtain a resonance wave;
comparing sub-waves of the resonance wave in different cycles to calculate a variation rate; and
determining the impurity content of the resistor:
   the variation rate is over a threshold, the impurity content is too much; or
   the variation rate is not over a threshold, the impurity content is compliant.

A method of detecting impurity content in a metal layer of a resistor, comprising:
measuring the metal layer to obtain a first resistance;
applying a pulse voltage to the resistor;
measuring the metal layer to obtain a second resistance;
comparing the first resistance with the second resistance to calculate a variation rate; and
determining the impurity content of the resistor:
   the variation rate is over a threshold, the impurity content is too much; or
   the variation rate is not over a threshold, the impurity content is compliant.

### BRIEF DESCRIPTION OF THE DRAWINGS

FIG. 1 is a diagram of resonance waveform of standard or defective resistor.
FIG. 2 is a diagram of resonance waveform of a defective resistor in different cycles.

### DESCRIPTION OF THE PREFERRED EMBODIMENTS

Various embodiments of the present invention will be described in detail as below, and the drawings will be used as examples to help readers to have a better understanding. In addition to these detailed descriptions, the present invention can also be widely implemented in other embodiments. Any substitutions, modifications, and equivalent changes of the embodiments should be understood to be included in the scope of the present invention. The scope of patents should be based on the scope of the claims. It should be noted that the drawings are for illustrative purposes only, and do not represent the actual size or quantity of the components. Some details may not be completely drawn in order to keep the drawings concise.

A method of detecting the impurity is provided by the present invention. A 3KV-6KV pulse voltage is applied to a resistor and the metal layer of the resistor generates a resonance wave. The metal layer of the resistor contains impurities if the resonance wave has an abnormal decay or fluctuation.

Another method of detecting the impurity is provided by the present invention. A standard resistor has a standard resonance wave when being applied by the 3KV~6KV pulse voltage. The pulse voltage is also applied to a test resistor to obtain a test resonance wave. An amplitude or an area of the test resonance wave is difference from standard resonance wave if the metal layer of the resistor contains impurities. It may be determined the impurity content of the test resistor according to whether the variation rate between the standard resonance wave and the test resonance wave is over a threshold or not.

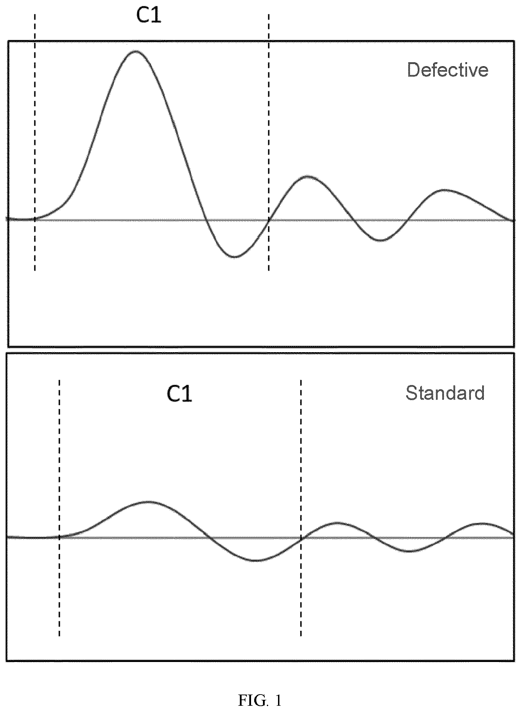

In an embodiment, a 4.5KV pulse voltage is applied to a non-impurity resistor to establish a standard resonance wave. The 4.5KV pulse voltage is also applied to a test resistor to obtain a test resonance wave. The deformation (variation) rate of the test resonance wave to the standard resonance wave can be calculated by a simple comparison, shown as FIG. 1. Impurity content of the test resistor is too much if the deformation rate is over a threshold, otherwise, impurity content of the test resistor is compliant if the deformation rate is not over a threshold. Wherein the threshold is defined as an amplitude of the test resonance wave is less than an amplitude of the standard resonance wave by more than 10% in first cycle, or the threshold is defined as an area of the test resonance wave is less than an area of the standard resonance wave by more than 1% in first cycle.

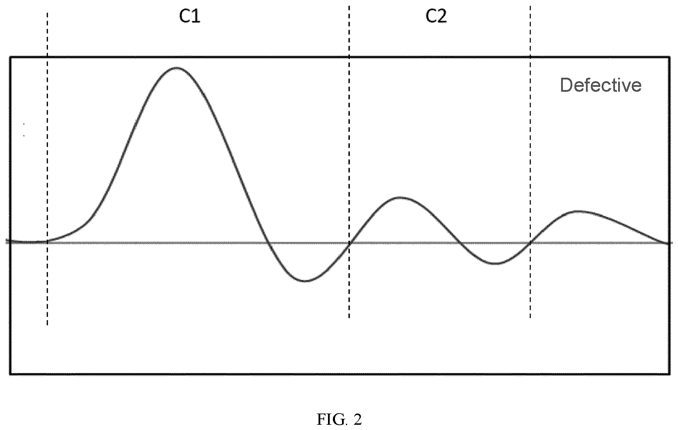

In an embodiment, a 4.5KV pulse voltage is applied to a resistor to obtain a resonance wave. The deformation rate of sub-waves of the resonance wave in different cycles can be calculated by a simple comparison, shown as FIG. 2. Impurity content of the resistor is too much if the deformation rate is over a threshold, otherwise, impurity content of the resistor is compliant if the deformation rate is not over a threshold. Wherein the threshold is defined as an amplitude of second cycle is less than an amplitude of first cycle by more than 30%.

In an embodiment, impurity content in metal layer of a resistor can be determined by comparing a first resistance and a second resistance measured respectively before and after applying a 4.5KV pulse voltage. The deformation rate between the first resistance and the second resistance can be calculated by a simple comparison. Impurity content of the resistor is too much if the deformation rate is over a threshold, otherwise, impurity content of the resistor is compliant if the deformation rate is not over a threshold, wherein the threshold is 0.1%.

In an embodiment, a resistor comprises multiple metal layers, and they can be different metal layer. In practice, more than one pulse voltage can be applied to the resistor, such as the resonance wave can be measured during the second and third pulse voltage, that is more stable to increase the accuracy of determent.

## Claims

1. A method of detecting impurity content in a metal layer of a resistor, comprising:
applying a pulse voltage to a non-impurity resistor to establish a standard resonance wave;
applying the pulse voltage to a test resistor to obtain a test resonance wave;
comparing the standard resonance wave with the test resonance wave to calculate a variation rate; and
determining the impurity content of the test resistor:
the variation rate is over a threshold, the impurity content is too much; or
the variation rate is not over a threshold, the impurity content is compliant.

2. The method according to claim 1, wherein the intensity of the pulse voltage is 3KV~6KV.

3. The method according to claim 1, wherein the threshold is defined as an amplitude of the test resonance wave is less than an amplitude of the standard resonance wave by more than 10% in first cycle.

4. The method according to claim 1, wherein the threshold is defined as an area of the test resonance wave is less than an area of the standard resonance wave by more than 1% in first cycle.

5. The method according to claim 1, wherein the resistor comprises multiple metal layers.

6. A method of detecting impurity content in a metal layer of a resistor, comprising:
applying a pulse voltage to the resistor to obtain a resonance wave;
comparing sub-waves of the resonance wave in different cycles to calculate a variation rate; and
determining the impurity content of the resistor:
the variation rate is over a threshold, the impurity content is too much; or
the variation rate is not over a threshold, the impurity content is compliant.

7. The method according to claim 6, wherein the intensity of the pulse voltage is 3KV~6KV.

8. The method according to claim 6, wherein the threshold is defined as an amplitude of second cycle is less than an amplitude of first cycle by more than 30%.

9. The method according to claim 6, wherein the resistor comprises multiple metal layers.

10. A method of detecting impurity content in a metal layer of a resistor, comprising:
measuring the metal layer to obtain a first resistance;
applying a pulse voltage to the resistor;
measuring the metal layer to obtain a second resistance;
comparing the first resistance with the second resistance to calculate a variation rate; and
determining the impurity content of the resistor:
the variation rate is over a threshold, the impurity content is too much; or
the variation rate is not over a threshold, the impurity content is compliant.

11. The method according to claim 10, wherein the threshold is 0.1%.
